# EUROPEAN PATENT SPECIFICATION

(11) **EP 2 818 730 B1**
(45) Date of publication and mention of the grant of the patent: **18.11.2020**
(21) Application number: 13305902.2
(22) Date of filing: 27.06.2013
(51) Int. Cl.: F04D 33/00, G01R 29/22, H01L 41/09

(54) **Method and apparatus for assessment and optimization of performance of piezoelectric devices**
Verfahren und Vorrichtung zur Beurteilung und Optimierung der Leistung von piezoelektrischen Vorrichtungen
Procédé et appareil d'évaluation et d'optimisation des performances de dispositifs piézo-électriques

(43) Date of publication of application: 31.12.2014
(73) Proprietor: Alcatel Lucent, 91620 Nozay (FR)
(72) Inventor: Jeffers, Nicholas, 15 Dublin (IE); Frizzell, Ronan, 15 Dublin (IE); Donnelly, Brian, 15 Dublin (IE)
(74) Representative: Nokia EPO representatives

(56) References cited:
- EP-A1- 1 865 311
- WO-A1-2009/057535
- US-A1- 2007 205 694
- US-A1- 2008 218 968
- YOO J H ET AL: "Piezoelectric ceramic bimorph coupled to thin metal plate as cooling fan for electronic devices", SENSORS AND ACTUATORS A, ELSEVIER SEQUOIA S.A., LAUSANNE, CH, vol. 79, no. 1, 1 January 2000 (2000-01-01), pages 8-12, XP004185119, ISSN: 0924-4247, DOI: 10.1016/S0924-4247(99)00249-6

## Description

The present invention relates to cooling devices using piezoelectric properties.

### BACKGROUND

A trend in producing electronic devices is toward reducing their size while enabling such devices to process increasingly larger volumes of data. Processing larger volumes of data typically involves higher levels of heat generation which in turn would require stronger and more efficient cooling mechanisms. In this regard passive heat transfer solutions (e.g. heat sinks) have been replaced or complemented by active cooling techniques which are typically capable of removing larger quantities of heat from an electronic component. One example of such active cooling techniques is based on the use of rotary fans. Herein, reference to the term rotary fan is to be understood to relate to an apparatus having vanes or blades or the like, connected to a rotor and capable of producing air flow by rotating the vanes in response to the action of the rotor. However there are drawbacks associated to the use of rotary fans as they are typically inherently unreliable with short life times (e.g. of about 7 years). Furthermore, the cost of ownership of equipment with fans is typically high and they occupy a relatively large volume.

### SUMMARY

Current and future electronic products may require higher performance and reliability coupled with lower product volume. In this regard, piezoelectric air movers (herein also referred to as piezofans) have gained significance.

On the other hand, the performance of cooling systems typically needs to be assessed regularly in order to ensure an optimized cooling operation. Active cooling systems are typically designed to operate at their optimum operational ranges (i.e. providing optimum cooling performance within the equipment they are designed to operate). Therefore, a failure or breakage in the operation of the cooling system may degrade the cooling efficiency and therefore give rise to overheating and damage to the electronic components that are to be cooled. Furthermore, such assessment is often needed to be carried out in the field, where the equipment is already installed, and has been in use for some time. Some assessment techniques for cooling systems using conventional rotary fans are known. Such techniques typically allow for providing the operator of the equipment to be cooled with sufficient feedback on the performance of the rotary fan so that its performance can be assessed in the field. The assessment may be performed by monitoring conditions near to the fan such as the air temperature downstream of the fan, pressure drops across the fan, or monitoring of vibrations of the fan housing, or monitoring of the fan speed, or the like. However, such methods typically require additional components that add to the cost of the cooling solution.

However, to the knowledge of the inventors, there is no known technique for assessing the performance of a blade of a piezofan. The present disclosure addresses this problem.

EP 1865311 A1 relates to a piezoelectric element inspection method, inspection device, and polarization processing method a processor.

US 2008/028968 relates to a winged piezofan.

US 2007/0205694 relates to a method of determining the natural frequency of a piezofan.

According to the present invention, a method is provided in accordance with claim 1 and a device in accordance with claim 9. Further preferred embodiments are defined in the dependent claims.

These and further features and advantages of the present disclosure are described in more detail, for the purpose of illustration and not limitation, in the following description as well as in the claims with the aid of the accompanying drawings.

### BRIEF DESCRIPTION OF THE DRAWINGS

Figure 1 is an exemplary schematic block diagram of a cooling arrangement.
Figure 2 is an exemplary schematic block diagram of a cooling arrangement in which an apparatus according to some embodiments of the disclosure may be implemented.
Figure 3 illustrates graphs representing response characteristics of a healthy piezoelectric air mover and a damaged piezoelectric air mover after discontinuing the application of electric energy in each case.
Figure 4 illustrates graphs representing ranges of oscillation amplitude of a healthy piezoelectric air mover and a damaged piezoelectric air mover after discontinuing the application of electric energy in each case.

### DETAILED DESCRIPTION

Before describing the embodiments of the present disclosure, a brief explanation is provided, with respect to an exemplary piezofan as known in the related art. This description is only provided for illustrative purposes and is not to be construed in a limiting manner.

Typically a piezoelectric device comprises a body of a solid material having the property of accumulating (generating) electric charge when a mechanical stress such as a pressure is applied thereupon. Conversely, such piezoelectric material exhibits a mechanical movement in response to an electric excitation (current or voltage) applied thereto. Some examples of materials exhibiting piezoelectric property are certain crystals or ceramics. One implementation of a piezoelectric device is a piezofan.

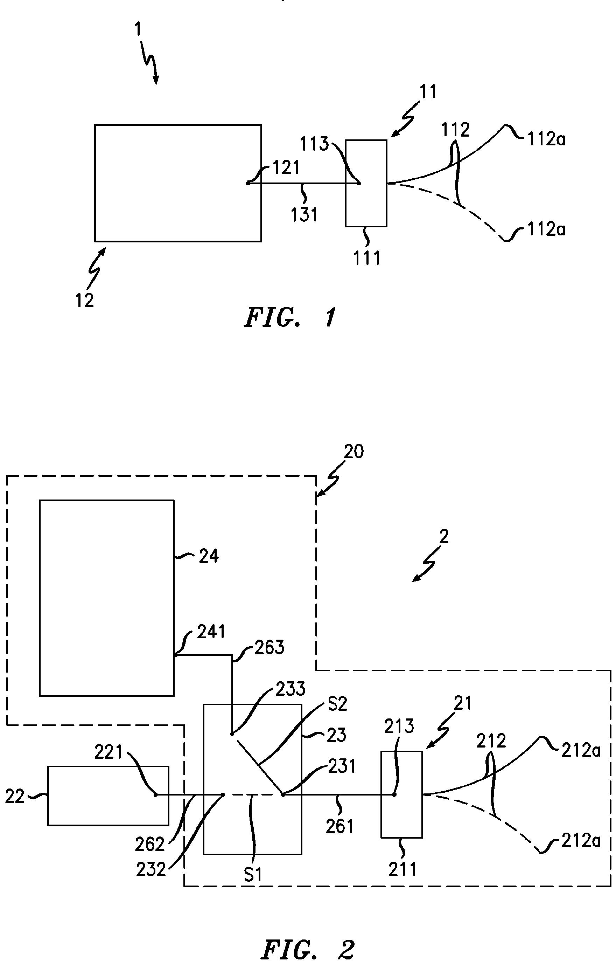

A piezofan is typically made of a piezoelectric element which is physically attached, e.g. bonded, to a planar, typically thin, body (sometimes referred to as blade or cantilever) the other end of the planar body being free and movable. When an alternating electric voltage (or current) is applied to the piezoelectric element, the latter exhibits an oscillating movement, causing the planar body to move. If the frequency of the alternating voltage is equal to the resonant frequency of the planar body, the latter produces an oscillating movement at the free end thereof at said resonant frequency. The oscillation of the free end of the planar body produces an air flow in a similar manner as a conventional hand fan. Conversely, assuming that no electric excitation is applied to the piezoelectric element, a movement of the free end of the planar body typically transfers mechanical stress to the body of the piezoelectric element. As a result of such mechanical stress, the piezoelectric element generates electric charge which may be measured in the form of electric current or voltage. In case the movement of the free end of the planar body is in the form of an oscillation, the piezoelectric element may generate an alternating current or alternating voltage. Figure 1 is an exemplary schematic block diagram of a cooling arrangement 1 comprising a piezofan 11 and a power source 12 as known in the related art. The piezofan 11 comprises a piezoelectric element 111 which may be made of any suitable piezoelectric material and a planar body (herein also referred to as blade) 112. The power source is configured to generate alternating electric voltage (or current) at a port 121 thereof. The port 121 is electrically connected to corresponding port 113 of the piezofan 11 by electric connection path 131.

The connection path 131 is represented in the figure by a single line. However, this is only done for simplicity of illustration and is not intended to represent a limitation to a one way, or single wire, connection. The connection path 131 may be provided in any convenient manner, for example using two wires, one for forward connection and one for return connection between the power source 12 and the piezofan 11, the two wires constituting the connection path 131. In the latter case, ports 121 and 113 may likewise each comprise a pair of contact points, one for forward connection and another for the return connection, and each pair of contact points may be considered to represent one port.

In operation, power source 12 may generate an alternating electric signal which is output from port 121 and is input into the piezoelectric element 111 through port 113. As mentioned above, such electric signal causes the piezoelectric element to undergo mechanical stress in the form of movements which are transferred to the blade 112 attached to the piezoelectric element 111 causing the blade 112 to move at the free end 112a thereof thereby generating a flow of air in the vicinity of the free end 112a. The blade 112 oscillates at the frequency of the alternating electric signal generated by the power source 12. If the frequency of the alternating electric signal matches the resonant frequency of the blade 112, the blade reaches its maximum deflection for the applied voltage. Figure 2 is an exemplary schematic block diagram of a cooling arrangement 2 comprising an apparatus 20 according to some embodiments of the disclosure. Such apparatus comprises a piezofan 21, a switch 23 and a processor 24. The piezofan 21 comprises a piezoelectric element 211, which may be made of any suitable piezoelectric material, and a planar body (or blade) 212.

The cooling arrangement 2 further comprises a power source 22. The power source 22 may be any suitable power source known in the related art and may be configured to generate alternating electric voltage or current at a port 221 thereof.

The piezofan 21 has a port 213 which, in the embodiment shown, may be used as an input port when the piezoelectric element 211 is configured to receive electric excitation, or it may be used as an output port when the piezoelectric element 211 is configured to generate electric charges.

In some embodiments, the piezoelectric element 211 may comprise an input port and an output port different from the input port such that current may enter the piezoelectric element from the input port and exit the piezoelectric element from the output port. The location of the ports on the piezoelectric element may be chosen according to the specific design requirements.

Switch 23 may be any suitable switch known in the related art; for example an electric or electronic relay switch or transistor. Switch 23 comprises first, second and third ports, 231, 232 and 233.

The processor 24 is configurable to receive an electric signal generated by the piezoelectric element 211 and process the signal to produce data useful or usable for assessing the performance of the blade 212, as will be described in further detail below. The processor 24 may be of any suitable type known in the related art and is to be understood in a broad sense as there are potentially various ways to detect electric signal output from the piezoelectric element and process said data corresponding to such detection. Some non-limiting examples of such processor may be microprocessors, FPGA, ASIC devices or analog components such as a comparator.. Processor 24 comprises port 241.

Similar to figure 1, in figure 2, the connection paths (261, 262 and 263) are represented by single lines. However, this is only done for simplicity of illustration and is not intended to represent a limitation to a one way, or single wire, connection. These connection paths may be provided in any convenient manner, for example using two wires, one for forward connection and one for return connection, the two wires in each case constituting a connection path. Likewise the ports (213, 221, 231, 232, 233 and 241) may each comprise a pair of contact points, one for forward connection and another for the return connection, and each pair of contact points may be considered to represent one port.

The electrical interconnection between the switch 23 and the piezofan 21, the power source 22 and the processor 24 respectively may be provided as follows: First port 231 of the switch 23 may be connected to port 213 of the piezofan 21 through a connection path 261 thereby providing electrical connectivity between the switch 23 and the piezofan 21.

Second port 232 of the switch 23 may be connected, according a first switching configuration to port 221 of the power source 22 through a connection path 262 thereby providing electrical connectivity between the switch 23 and the power source 22.

Third port 233 of the switch 23 may be connected, according to a second switching configuration, to port 241 of the processor 24 through respective connection path 263 thereby providing electrical connectivity between the switch 23 and the processor 24.

With the arrangement as described above and shown in figure 2, switch 23, from an electrical connectivity viewpoint, is located between the power source 22, the processor 24 and the piezofan 21 and is capable of switching the piezofan 21 to be connected to the power source 22 or the processor 24.

In operation, when switch 23 is in the first switching configuration, shown in the figure by broken line S1, an electric excitation (e.g. alternating voltage) generated by power source 22 may be output from port 221 and input into the piezoelectric element 211 at port 213 through port 232, switch path S1 and port 231. As mentioned above, such electric excitation causes the piezoelectric element 211 to undergo mechanical stress in the form of movements which are transferred to the blade 212 attached to the piezoelectric element 211 causing the blade 212 to oscillate at the free end 212a thereof; thereby generating a flow of air in the vicinity of the free end 212a. If the frequency of the alternating electric signal generated by the power source 22 is equal to the resonant frequency of the blade 212, then the blade 212 may oscillate at such resonant frequency.

The first switching configuration therefore closes a circuit which allows the piezofan to operate in a condition which, for ease of understanding, may be referred to as a normal operating condition.

In such normal operating condition, the blade 212, assuming being free of damage, is oscillating at a frequency, which in optimal conditions, would be its resonant frequency.

If the switch 23 is activated to pass from the first switching configuration (path S1) to the second switching configuration, shown in the figure by solid line S2, then the electric excitation of piezoelectric element 211, supplied by the power source 22, becomes interrupted. However, blade 212 will continue to oscillate due to a strain energy stored in the blade and/or the momentum of the blade. Such oscillation however will decay in amplitude until it reaches complete stop (zero amplitude). Indeed, when the electrical signal is stopped, the strain energy is converted to kinetic energy and this gives rise to the blades momentum. However, when the blade reaches its neutral position (zero oscillation amplitude) it has no strain energy but the blade will continue to move past this neutral position due to the momentum stored therein. The strain energy then builds up again and, when it reaches a high enough level, it causes the blade to change direction. This will continue until the motion is damped out giving the observed oscillations. Therefore, in the oscillation of the blade after the interruption of the electric excitation, both the momentum and the strain energy may act separately or interact in combination.

This oscillation causes the blade 212 to exert mechanical stress on the body of the piezoelectric element 211 attached thereto, thereby generating electric charges which may be detected by an external unit in the form of electric current or voltage.

As the oscillation of the blade 212 without electric excitation decays to zero (reaching complete stop), the electric current or voltage generated by the piezoelectric element would also decay to zero. Such current or voltage may be detected and measured at port 213 which is also available at ports 231 and 233. Information corresponding to the measurement of the current or voltage, at port 233, may then be used to produce data which is useful or usable for assessing the performance of the blade as will be described in further detail below.

The second switching configuration therefore closes a circuit which allows the piezofan to operate in a condition which, for ease of understanding, may be referred to as an assessment condition. In practice, the interruption of supply of electric excitation to the blade 212 may last for a fraction of a second (0.1s) and after such interruption the excitation may be resumed to return the blade back to the normal operating condition.

Although in the example illustrated in figure 2, the piezofan 21 is shown to have only one piezoelectric element, the disclosure is not so limited. Indeed, the piezofan may comprise any suitable number of piezoelectric elements attached to the blade. For example, various piezoelectric elements may be attached to one surface of the blade such that each piezoelectric element contributes to the oscillation of the blade in normal operating conditions; and generates an electric signal in response to mechanical stress caused by the movement of the blade on that piezoelectric element, in assessment conditions.

Furthermore, one or more piezoelectric elements may be attached to one surface while one or more piezoelectric elements may be attached to the other (opposite) surface of the blade. In this configuration, the piezoelectric elements on each side (surface) of the blade may cause opposing actions on the blade during the normal operating conditions, which may contribute to the oscillation (e.g. at one instance one piezoelectric element causing the blade to deflect away from it, as if it was pushing the blade, and the other piezoelectric element causing the blade to deflect toward it, as if it was pulling the blade, and vice-versa); whereas in assessment conditions, each piezoelectric element may generate an electric signal in response to mechanical stress caused by the movement of the blade on that piezoelectric element.

In any of the examples above related to the presence of more than one piezoelectric element, the electric signal generated by each of the individual piezoelectric elements may be added up to obtain a single electric signal being the sum of each individual electric signal. Such single electric signal may then be used in the assessment process as discussed above. Alternatively, the electric signal generated by each of the individual piezoelectric elements may each be assessed individually to thereby enable an overall assessment of the performance of the piezofan. A combination of the above is also possible, namely while some individual electric signals may be added up to obtain a summed up electric signal to be used in the assessment process, some other individual electric signals may be used individually in the assessment process.

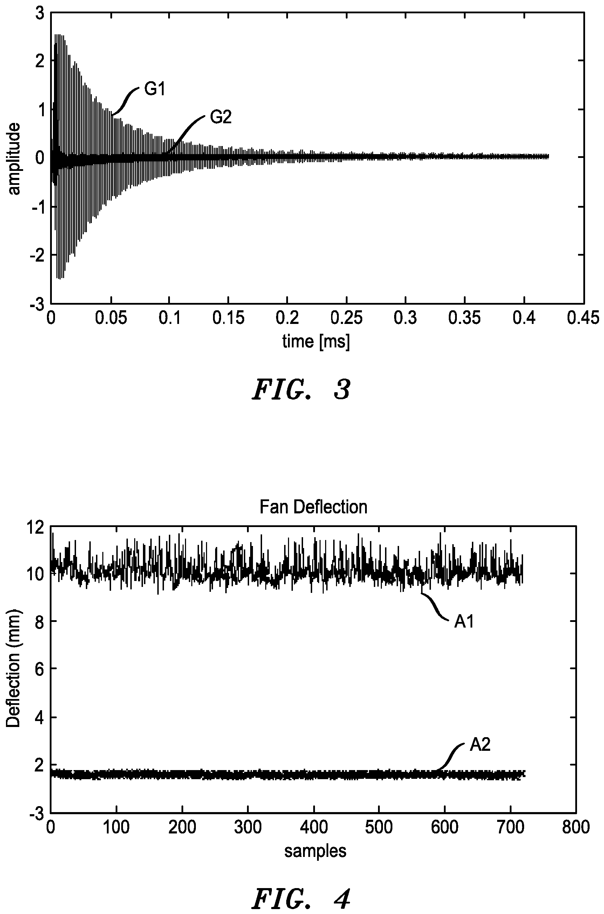

Referring now to figure 3, response characteristics of a healthy piezofan is compared to the response characteristics of a damaged piezofan. Such response relates, in each case, to the behavior of the piezofan after the electric excitation has been interrupted as discussed above (i.e. the assessment condition in the second switching configuration) and shows variations of amplitude with respect to time in milliseconds (ms), where such amplitude may represent voltage, current or a combination of both, or any value derived using current or voltage measurement, e.g. power. Graph G1 corresponds to the healthy piezofan and graph G2 corresponds to the damaged piezofan.

In the context of the present disclosure, a healthy piezofan may be understood to be a piezofan having either a blade or a piezoelectric element which is substantially free of damage to the structure of the blade or the piezoelectric element such as breakage; and/or a piezoelectric element which is substantially free of degradation due to external factors, fatigue or wear; and/or free of contamination from external sources such as dust and debris. Likewise a piezofan having a damaged blade or damaged piezoelectric element or damaged bonding between the piezoelectric element and the blade, will be referred to as a damaged piezofan.

Furthermore, the term damage in the context of the present disclosure is to be understood to relate to not only physical damage to the structure of the piezofan, including blade or the piezoelectric element, but also any type of degradation due to due to external factors, fatigue or wear; and/or due to contamination from external sources such as dust and debris.

It is to be noted that the graphs of figure 3 are generated by experimental measurement and are provided only for illustrative purposes. Therefore, these graphs are not to be construed as having any limiting effect as to what they represent.

In the following, examples are provided in which the blade of the piezofan is assumed to be damaged (e.g. broken). However, the disclosure is not so limited and the solution provided herein is likewise applicable to piezofans having damaged piezoelectric elements.

As it may be readily appreciated from the graphs, there is a substantial difference between the performance of the healthy piezofan (graph G1) as compared to the damaged one (graph G2). It therefore may be concluded that such difference in response occurs because the broken blade has a smaller displacement in terms of amplitude of oscillation as compared to the undamaged blade when it is operating and therefore has less momentum and/or stored strain energy when it is switched off and thus lower power is generated.

An example of this difference in the respective amplitudes of oscillation is represented in figure 4 in which graph A1 corresponds to the healthy piezofan and graph A2 corresponds to the damaged piezofan. Here again, the graphs are generated by experimental measurement and are provided only for illustrative purposes and are not to be construed as having any limiting effect as to what they represent.

The graphs represent examples of amplitude of oscillation in terms of the deflection of the tip of two blades calculated from the electrical signal generated by each blade measured by the circuit arrangement described in the embodiment of figure 2. The graphs are derived by integrating the initial 0.02 seconds of the decaying signal in figure 3 and relating this to the known deflection of a healthy piezofan.

In practice it may be considered that when the calculated displacement of the tip of the blade falls below a predefined threshold, say 8 mm, the blade is considered to be damaged and no longer performing; in which case the operator may be alerted to replace the blade.

A further advantage of the solution provided is that it allows for determining the real resonant frequency of a blade, as opposed to nominal or factory designated value, at any given time. Indeed, the resonant frequency of a blade may change over time due to various reasons, for example dust accumulation or mechanical fatigue. Conducting the assessment process as disclosed herein will allow for determining the resonant frequency with which the blade is actually working. In case such resonant frequency has changed from its original, or nominal, value, corrective measures may be taken to restore the blade's operation at its resonant frequency (even if the latter resonant frequency has changed and is different from nominal resonant frequency). In this regard one corrective measure may be for example automatically or manually tuning the frequency of the alternating signal which is input into the piezoelectric element, to the blade's resonant frequency when the blade is in-situ in the product. Furthermore, the capability of automatically tuning to the blade's resonant frequency may become critical as moving only a few hertz from the precise resonance frequency may significantly reduce the performance of the piezofan. The results from the assessment can also flag a service engineer to replace a unit when the blade's performance drops below a certain level, preventing potential overheating problems associated with the blade's poor performance.

The above tuning procedure may likewise be employed in case a blade is broken (or has suffered other structural damage). This situation may become particularly relevant if fouling occurs on the blade and causes the mass of the device to change, as this alters the blade's resonant frequency. This problem may occur in the field and may result in a dramatic reduction in blade performance due to only slight changes to the resonance frequency.

As a solution in such occasions, the performance of the piezofan as described above with reference to figure 3 may be assessed. Next, the response generated by the damaged piezofan may be converted from a signal varying in the time domain into one with variation in the frequency domain (e.g. using fast Fourier transform), highlighting the various dominant frequencies in the signal. Such frequency domain representation may then show a peak in the resulting curve which would be a representation of the real resonant frequency of the damaged blade. Therefore, an assessment may be made to determine whether the frequency of the alternating input signal is different from the represented resonant frequency of the damaged blade, a controlling circuit may then be programmed to change the frequency of the input signal to the represented resonant frequency of the damaged blade so that the maximum performance is maintained, or at least optimal performance is ensured until the damaged blade is replaced by an undamaged one. This process will be further described below. The processor 24 for assessing the performance of the piezofan may be implemented using a variety of techniques and involving the use of hardware and/or software therein.

In some embodiments of the processor, software may be used for detection and analysis of the electric signal generated by the piezoelectric element 211. In such cases, the processor may be suitably programmed so as to receive the electric signal, produce data based on the received signal for example during a certain time interval and interpret said data. Programming a processor, such as a microprocessor, with appropriate software would be within the capabilities of a person of ordinary skill in the related art.

In some embodiments, the same processor may be configured to record the electric signal received from the piezofan, generate data useful for assessing the performance of the blade and perform the assessment operation based on said generated data.

In some alternative embodiments, the processor may be configured to record the electric signal received from the piezofan and generate data useful for assessing the performance of the blade and send said generated data to a second component (e.g. another microprocessor or a computer) to perform the assessment operation based on said generated data.

In either of the above embodiments, configuring such arrangement, which may require appropriate programming, would be within the capabilities of a person of ordinary skill in the related art.

In some embodiments, instead of using software, hardware components only may be used to assess the performance of the piezofan. For example a comparator may be used which may sample the voltage (or current) generated by the piezofan at predetermined intervals and compare such sampled value with the voltage (or current) generated by the piezofan when it is operating in healthy conditions. If a difference is detected between the two sampled voltages, such difference may be indicative of damage in the piezofan operation.

Some non-limiting techniques for assessing the performance of the blade by the processor are now described.

According to one technique, when the electric excitation driving the piezofan is interrupted, as described above, the electric signal (voltage, current or both) generated by the piezofan may be recorded for a predetermined period of time. The result may be for example in the form of a graph similar to that shown in Figure 3. A range of metrics can then be used to determine the condition of the piezofan using this information.

In one embodiment, the area under the voltage-time graph (figure 3) may be determined between two or more given time points and used as a means for determining the condition of the blade. The size of the measured area may therefore be compared to a corresponding measured value of a healthy blade (determined in advance) and based on such comparison, it may be determined whether or not the blade is damaged.

A further technique for assessing the performance of the blade may be the rate of decay of the recorded electric signal. Such rate may be determined using standard mathematical methods from data similar to that shown in figure 3. The rate of decay is an indication of the health of the blade since damaged blades would have a more rapid decay compared to healthy blades.

Another technique may be based on determining the amount of the deflection of the blade which is proportional to the electric excitation (voltage or current) generated by the piezoelectric element. Variation of the deflection, e.g. of the tip of the blade, as a function of the applied excitation may be recorded and stored as reference information. Such information may then be used in the inverse sense, i.e. for determining how the voltage or current generated by the piezoelectric element varies with the deflection of the blade in the assessment condition. In this manner, if the peak voltage or current is monitored when the driving signal is stopped this can be used to determine the deflection, e.g. of the tip, (for each cycle of deflection), thereby allowing for identifying a damaged blade not achieving the desired or nominal displacement. For example a number of peak voltage samples may be recorded for a healthy blade and compared to peak voltage samples of a damaged blade. The differences between these two sets of results can then be used to determine whether the blade is damaged. Another assessment technique may use a fast Fourier transform (FFT) carried out on the signal received and recorded by the processor. This is a well known method that may provide information on the strength of a signal at various frequencies. For example if a voltage is measured by the processor, the FFT may be employed to show the voltage generated at different frequencies. A healthy blade would be expected to show high voltage at the blade's resonant frequency, while a damaged blade would demonstrate considerably lower voltage.

As already mentioned above, such FFT technique may also be used to identify if a blade's characteristics have changed. For example, if a blade becomes contaminated with dust its resonant frequency would change due to the increase in mass. This can be detected by recording, for example, the voltage (or current) generated by the piezofan for a period of time with the driving signal turned off and carrying out an FFT on the recorded data. The frequency where the maximum voltage (or current) is given by the FFT would indicate the natural (new resonant) frequency of the piezofan or the blade in the new condition, for example contaminated with dust. As a remedy, the power source may be adjusted to change the frequency of the driving electric signal to match the new resonant frequency of the blade and therefore ensure an optimum deflection thereof.

The above techniques may involve the use of digital processing devices such as a microprocessor programmed with suitable software. However, it is also possible to use analog components, such as voltage or current comparators, to sample the voltage (or current) and to compare the sampled values with known values, or with previously measured values, that are representative of healthy blades.

Still a further technique may be based on the use of the electric charge generated by the piezofan, when the power is switched off. Such electric charge or electric signal) may be fed, in total or in part, to a detection circuit which may be switched from one state to another (e.g. on/off or vice-versa) in response to receiving the electric charge. A sufficiently strong electric signal (in terms of voltage, current or power) may trigger the switching (on or off) of the detection circuit. Therefore, in case the electric excitation of the piezofan is interrupted and the electric signal generated by the piezofan after such interruption is not sufficient to switch the detection circuit, then it may be concluded that the blade of the piezofan is damaged.

In any of the above circumstances, using digital or analog components, the data corresponding to the detected or sampled electric signal generated by the piezoelectric element in the assessment condition, may be transmitted to another location where data analysis, as described above, may be carried out for example using a computer. The transmission may be performed through wireless or wired techniques.

Based on the results of this type of analysis signals may be sent to operators to alert about potentially damaged piezofans requiring replacement or repair.

The various embodiments or techniques of the present disclosure may be combined as long as such combination is compatible and/or complimentary.

The list of structures corresponding to the claimed means is not exhaustive and that one skilled in the art understands that equivalent structures can be substituted for the recited structure without departing from the scope of the disclosure.

It should be appreciated by those skilled in the art that any block diagrams herein represent conceptual views of illustrative circuitry embodying the principles of the disclosure.

## Claims

1. A method comprising:
- applying, in a first switching configuration, electric excitation to a piezofan comprising a piezoelectric element attached to a first end of a planar body, causing the planar body to move, said planar body having a second end which is free to move;
- coupling, in a second switching configuration, the piezoelectric element to a processor;
- receiving, by the processor, an electric signal generated by the piezoelectric element caused by a movement of the planar body in the second switching configuration,
- generating, by the processor, data corresponding to said electric signal for assessing a performance of the piezofan;
- analyzing said data for assessing the performance of the piezofan, wherein said analysis of data comprises comparing said data with other data corresponding to an electric signal generated by the piezoelectric element caused by a movement of the planar body in a healthy piezofan condition, or with a predefined threshold value.

2. The method of claim 1 wherein said data corresponds to a maximum amplitude of oscillation of the planar body under assessment and said other data corresponds to a maximum of oscillation of the planar body in a healthy piezofan condition.

3. The method of claim 1 wherein said data corresponds to a variation as a function of time of the electric signal generated by the piezoelectric element caused by the movement of the planar body under assessment and said other data corresponds to a variation as a function of time of the electric signal generated by the piezoelectric element caused by the movement of the planar body in a healthy piezofan condition.

4. The method of claim 1 wherein said data corresponds to a rate of decay of the electric signal generated by the piezoelectric element caused by the movement of the planar body under assessment and said other data corresponds to a rate of decay of the electric signal generated by the piezoelectric element caused by the movement of the planar body in a healthy piezofan condition.

5. The method of claim 1 wherein said data corresponds to a first fast Fourier transform performed on the electric signal generated by the piezoelectric element caused by the movement of the planar body under assessment and said other data corresponds to a second fast Fourier transform performed on the electric signal generated by the piezoelectric element caused by the movement of the planar body in a healthy piezofan condition.

6. The method of claim 5 further comprising:
- determining from said first fast Fourier transform a frequency corresponding to a maximum value of the electric signal; and
- adjusting a frequency of the electric excitation to the piezoelectric element to match said obtained frequency.

7. The method of claim 1 wherein said analysis comprises:
- supplying at least a portion of the electric signal generated by the piezoelectric element to a detection circuit; and
- switching said detection circuit from one state to another in response to receiving said electric signal where such electric signal has a strength above a threshold value.

8. The method of claim 1, wherein said data is transmitted to a component different from the processor, configured for analyzing said data for assessing the performance of the piezofan.

9. An apparatus comprising:
- a piezofan having a planar body attached to a first end of a piezoelectric element capable of moving the planar body, said planar body having a second end which is free to move;
- a processor; and
- a switch configured to couple the piezoelectric element to a power source in a first switching configuration and to couple the piezoelectric element to the processor in a second switching configuration;
wherein the processor is configured to receive an electric signal generated by the piezoelectric element caused by a movement of the planar body in the second switching configuration and to generate data corresponding to said electric signal for assessing a performance of the piezofan; and
wherein the processor is configured to analyze said data for assessing the performance of the piezofan, said analysis of data comprises comparing said data with other data corresponding to an electric signal generated by the piezoelectric element caused by a movement of the planar body in a healthy piezofan condition, or with a predefined threshold value.

10. The apparatus of claim 9 wherein said processor is configured to perform the steps of any one of the claims 1 to 7.

11. The apparatus of claim 9 wherein said processor is a digital processing device, or an analog comparator.

12. The apparatus of claim 9 further comprising a detection circuit configured to switch states in response to receiving at least a portion of the electric signal generated by the piezoelectric element where such electric signal has a strength above a threshold value.

13. The apparatus of claim 9 configured to transmit said data to a component different from the processor, configured for analyzing said data for assessing the performance of the piezofan.

14. The apparatus of claim 9 comprising:
- more than one piezoelectric elements attached to a first surface of the planar body; or
- one or more piezoelectric elements attached to the first surface and one or more piezoelectric elements attached to a second surface of the planar body.

15. A cooling arrangement comprising the apparatus of claim 9.

16. The cooling arrangement of claim 4615, further comprising a component different from the processor, configured for analyzing said data for assessing the performance of the piezofan.

17. The cooling arrangement of claim 16, wherein said component is configured to perform the steps of any one of the claims 1 to 7.

## Patentansprüche

1. Verfahren, umfassend:
- Aufbringen einer elektrischen Erregung in einer ersten Schaltkonfiguration auf einen Piezofan, der ein an einem ersten Ende eines ebenen Körpers angebrachtes piezoelektrisches Element umfasst, wodurch der ebene Körper bewegt wird, wobei der ebene Körper ein zweites Ende aufweist, das frei beweglich ist;
- Koppeln des piezoelektrischen Elements in einer zweiten Schaltkonfiguration mit einem Prozessor;
- Empfangen eines durch das piezoelektrische Element erzeugten elektrischen Signals durch den Prozessor, das durch eine Bewegung des ebenen Körpers in der zweiten Schaltkonfiguration verursacht wird,
- Erzeugen von Daten durch den Prozessor entsprechend dem elektrischen Signal, um eine Leistung des Piezofans zu beurteilen;
- Analysieren der Daten zum Beurteilen der Leistung des Piezofans, wobei die Analyse der Daten das Vergleichen der Daten mit anderen Daten entsprechend einem durch das piezoelektrische Element erzeugten elektrischen Signals, das durch eine Bewegung des ebenen Körpers in einem gesunden Piezofan-Zustand bewirkt wird, oder mit einem vordefinierten Schwellenwert umfasst.

2. Verfahren nach Anspruch 1, wobei die Daten einer maximalen Schwingungsamplitude des zu beurteilenden ebenen Körpers entsprechen und die anderen Daten einem Schwingungsmaximum des ebenen Körpers in einem gesunden Piezofan-Zustand entsprechen.

3. Verfahren nach Anspruch 1, wobei die Daten einer zeitlichen Änderung des durch das piezoelektrische Element erzeugten elektrischen Signals entsprechen, das durch die Bewegung des zu beurteilenden ebenen Körpers verursacht wird, und die anderen Daten einer zeitlichen Änderung des durch das piezoelektrische Element erzeugten elektrischen Signals entsprechen, das durch die Bewegung des ebenen Körpers in einem gesunden Piezofan-Zustand verursacht wird.

4. Verfahren nach Anspruch 1, wobei die Daten einer Abklingrate des durch das piezoelektrische Element erzeugten elektrischen Signals entsprechen, das durch die Bewegung des zu beurteilenden ebenen Körpers verursacht wird, und die anderen Daten einer Abklingrate des durch das piezoelektrische Element erzeugten elektrischen Signals entsprechen, das durch die Bewegung des ebenen Körpers in einem gesunden Piezofan-Zustand verursacht wird.

5. Verfahren nach Anspruch 1, wobei die Daten einer ersten schnellen Fourier-Transformation entsprechen, die an dem durch das piezoelektrische Element erzeugten elektrischen Signal durchgeführt wird, das durch die Bewegung des zu beurteilenden ebenen Körpers verursacht wird, und die anderen Daten einer zweiten schnellen Fourier-Transformation entsprechen, die an dem durch das piezoelektrische Element erzeugten elektrischen Signal durchgeführt wird, das durch die Bewegung des ebenen Körpers in einem gesunden Piezofan-Zustand verursacht wird.

6. Verfahren nach Anspruch 5, ferner umfassend:
- Bestimmen einer einem Maximalwert des elektrischen Signals entsprechenden Frequenz aus der ersten schnellen Fourier-Transformation; und
- Einstellen einer Frequenz der elektrischen Erregung des piezoelektrischen Elements, um die erhaltene Frequenz abzugleichen.

7. Verfahren nach Anspruch 1, wobei die Analyse umfasst:
- Zuführen mindestens eines Teils des durch das piezoelektrische Element erzeugten elektrischen Signals zu einer Erkennungsschaltung; und
- Schalten der Erkennungsschaltung aus einem Zustand in einen anderen als Reaktion auf das Empfangen des elektrischen Signals, wenn das elektrische Signal eine Stärke oberhalb eines Schwellenwerts aufweist.

8. Verfahren nach Anspruch 1, wobei die Daten an eine von dem Prozessor verschiedene Komponente übertragen werden, die zum Analysieren der Daten zum Beurteilen der Leistung des Piezofans ausgelegt ist.

9. Vorrichtung, umfassend:
- einen Piezofan, der einen ebenen Körper aufweist, der an einem ersten Ende eines piezoelektrischen Elements angebracht ist, das in der Lage ist, den ebenen Körper zu bewegen, wobei der ebene Körper ein zweites Ende aufweist, das frei beweglich ist;
- einen Prozessor; und
- einen Schalter, der dazu ausgelegt ist, das piezoelektrische Element in einer ersten Schaltkonfiguration mit einer Stromquelle zu koppeln und in einer zweiten Schaltkonfiguration das piezoelektrische Element mit dem Prozessor zu koppeln;
wobei der Prozessor dazu ausgelegt ist, ein durch das piezoelektrische Element durch eine Bewegung des ebenen Körpers in der zweiten Schaltkonfiguration erzeugtes elektrisches Signal zu empfangen und dem elektrischen Signal entsprechende Daten zum Beurteilen einer Leistung des Piezofans zu erzeugen; und
wobei der Prozessor dazu ausgelegt ist, die Daten zum Beurteilen der Leistung des Piezofans zu analysieren, wobei die Datenanalyse das Vergleichen der Daten mit anderen Daten entsprechend einem durch das piezoelektrische Element durch eine Bewegung des ebenen Körpers in einem gesunden Piezofan-Zustand erzeugten elektrischen Signal oder mit einem vordefinierten Schwellenwert umfasst.

10. Vorrichtung nach Anspruch 9, wobei der Prozessor dazu ausgelegt ist, die Schritte eines der Ansprüche 1 bis 7 durchzuführen.

11. Vorrichtung nach Anspruch 9, wobei der Prozessor eine digitale Verarbeitungsvorrichtung oder ein analoger Komparator ist.

12. Vorrichtung nach Anspruch 9, ferner umfassend eine Erkennungsschaltung, die dazu ausgelegt ist, Zustände als Reaktion auf das Empfangen mindestens eines Teils des durch das piezoelektrische Element erzeugten elektrischen Signals umzuschalten, wenn das elektrische Signal eine Stärke oberhalb eines Schwellenwerts aufweist.

13. Vorrichtung nach Anspruch 9, die dazu ausgelegt ist, die Daten an eine von dem Prozessor verschiedene Komponente zu übertragen, die dazu ausgelegt ist, die Daten zum Beurteilen der Leistung des Piezofans zu analysieren.

14. Vorrichtung nach Anspruch 9, umfassend:
- mehrere piezoelektrische Elemente, die an einer ersten Fläche des ebenen Körpers angebracht sind; oder
- ein oder mehrere piezoelektrische Elemente, die an der ersten Fläche angebracht sind, und ein oder mehrere piezoelektrische Elemente, die an einer zweiten Fläche des ebenen Körpers angebracht sind.

15. Kühlanordnung, die die Vorrichtung nach Anspruch 9 umfasst.

16. Kühlanordnung nach Anspruch 15, ferner umfassend eine von dem Prozessor verschiedene Komponente, die zum Analysieren der Daten zum Beurteilen der Leistung des Piezofans ausgelegt ist.

17. Kühlanordnung in nach Anspruch 16, wobei die Komponente dazu ausgelegt ist, die Schritte eines der Ansprüche 1 bis 7 durchzuführen.

## Revendications

1. Procédé comprenant :
- dans une première configuration de commutation, l'application, à un piezo-ventilateur comprenant un élément piézoélectrique fixé à une première extrémité d'un corps plan, d'une excitation électrique faisant bouger le corps plan, ledit corps plan ayant une deuxième extrémité qui est libre de bouger ;
- dans une deuxième configuration de commutation, le couplage de l'élément piézoélectrique à un processeur ;
- la réception, par le processeur, d'un signal électrique généré par l'élément piézoélectrique sous l'effet d'un mouvement du corps plan dans la deuxième configuration de commutation ;
- la génération, par le processeur, de données correspondant audit signal électrique pour l'évaluation de performances du piezo-ventilateur ;
- l'analyse desdites données pour l'évaluation des performances du piezo-ventilateur, ladite analyse des données comprenant la comparaison desdites données à d'autres données correspondant à un signal électrique généré par l'élément piézoélectrique sous l'effet d'un mouvement du corps plan dans une condition de bonne santé du piezo-ventilateur ou à une valeur seuil prédéfinie.

2. Procédé selon la revendication 1, dans lequel lesdites données correspondent à une amplitude d'oscillation maximale du corps plan en cours d'évaluation et lesdites autres données correspondent à un maximum d'oscillation du corps plan dans une condition de bonne santé du piezo-ventilateur.

3. Procédé selon la revendication 1, dans lequel lesdites données correspondent à une variation en fonction du temps du signal électrique généré par l'élément piézoélectrique sous l'effet du mouvement du corps plan en cours d'évaluation et lesdites autres données correspondent à une variation en fonction du temps du signal électrique généré par l'élément piézoélectrique sous l'effet du mouvement du corps plan dans une condition de bonne santé du piezo-ventilateur.

4. Procédé selon la revendication 1, dans lequel lesdites données correspondent à un taux de décroissance du signal électrique généré par l'élément piézoélectrique sous l'effet du mouvement du corps plan en cours d'évaluation et lesdites autres données correspondent à un taux de décroissance du signal électrique généré par l'élément piézoélectrique sous l'effet du mouvement du corps plan dans une condition de bonne santé du piezo-ventilateur.

5. Procédé selon la revendication 1, dans lequel lesdites données correspondent à une première transformée de Fourier rapide effectuée sur le signal électrique généré par l'élément piézoélectrique sous l'effet du mouvement du corps plan en cours d'évaluation et lesdites autres données correspondent à une deuxième transformée de Fourier rapide effectuée sur le signal électrique généré par l'élément piézoélectrique sous l'effet du mouvement du corps plan dans une condition de bonne santé du piezo-ventilateur.

6. Procédé selon la revendication 5, comprenant en outre :
- la détermination, à partir de ladite première transformée de Fourier rapide, d'une fréquence correspondant à une valeur maximale du signal électrique ; et
- l'ajustement d'une fréquence de l'excitation électrique de l'élément piézoélectrique pour qu'elle corresponde à ladite fréquence obtenue.

7. Procédé selon la revendication 1, dans lequel ladite analyse comprend :
- l'envoi d'au moins une partie du signal électrique généré par l'élément piézoélectrique à un circuit de détection ; et
- la commutation dudit circuit de détection d'un état à un autre en réponse à la réception dudit signal électrique, lequel signal électrique ayant une intensité supérieure à une valeur seuil.

8. Procédé selon la revendication 1, dans lequel lesdites données sont transmises à un composant différent du processeur, configuré pour analyser lesdites données pour évaluer les performances du piezo-ventilateur.

9. Appareil comprenant :
- un piezo-ventilateur ayant un corps plan fixé à une première extrémité d'un élément piézoélectrique capable de faire bouger le corps plan, ledit corps plan ayant une deuxième extrémité qui est libre de bouger ;
- un processeur ; et
- un commutateur configuré pour coupler l'élément piézoélectrique à une source d'alimentation dans une première configuration de commutation et pour coupler l'élément piézoélectrique au processeur dans une deuxième configuration de commutation ;
le processeur étant configuré pour recevoir un signal électrique généré par l'élément piézoélectrique sous l'effet d'un mouvement du corps plan dans la deuxième configuration de commutation et pour générer des données correspondant audit signal électrique pour l'évaluation de performances du piezo-ventilateur ; et
le processeur étant configuré pour analyser lesdites données pour évaluer les performances du piezo-ventilateur, ladite analyse des données comprenant la comparaison desdites données à d'autres données correspondant à un signal électrique généré par l'élément piézoélectrique sous l'effet d'un mouvement du corps plan dans une condition de bonne santé du piezo-ventilateur ou à une valeur seuil prédéfinie.

10. Appareil selon la revendication 9, dans lequel ledit processeur est configuré pour exécuter les étapes selon l'une quelconque des revendications 1 à 7.

11. Appareil selon la revendication 9, dans lequel ledit processeur est un dispositif de traitement numérique, ou un comparateur analogique.

12. Appareil selon la revendication 9, comprenant en outre un circuit de détection configuré pour changer d'état en réponse à la réception d'au moins une partie du signal électrique généré par l'élément électrique, lequel signal électrique ayant une intensité supérieure à une valeur seuil.

13. Appareil selon la revendication 9, configuré pour transmettre lesdites données à un composant différent du processeur, configuré pour analyser lesdites données pour évaluer les performances du piezo-ventilateur.

14. Appareil selon la revendication 9, comprenant :
- plus d'un élément piézoélectrique fixé à une première surface du corps plan ; ou
- un ou plusieurs éléments piézoélectriques fixés à la première surface et un ou plusieurs éléments piézoélectriques fixés à une deuxième surface du corps plan.

15. Agencement de refroidissement comprenant l'appareil selon la revendication 9.

16. Agencement de refroidissement selon la revendication 15, comprenant en outre un composant différent du processeur, configuré pour analyser lesdites données pour évaluer les performances du piezo-ventilateur.

17. Agencement de refroidissement selon la revendication 16, dans lequel ledit composant est configuré pour exécuter les étapes selon l'une quelconque des revendications 1 à 7.
